# EUROPEAN PATENT APPLICATION

(11) **EP 4 472 362 A1**
(43) Date of publication of application: **04.12.2024**
(21) Application number: 23382507.4
(22) Date of filing: 30.05.2023
(51) Int. Cl.: H05K 1/18, H05K 3/00, H05K 3/30, H05K 1/02

(54) **MANUFACTURING METHOD OF AN ELECTRONIC DEVICE COMPRISING A NON-FLAT LAMINAR ITEM WITH A NON-FLAT ELECTRONIC CIRCUIT THEREON**

(71) Applicant: Fundació Eurecat, 08290 Cerdanyola del Vallès (ES)
(72) Inventor: FONTDECABA BAIG, Enric, 08290 Cerdanyola del Vallès (ES); LACHARMOISE, Paul Dominique, 08302 Mataró (ES); ARROYO MOSO, Iker, 08015 Barcelona (ES); VILAR ABRIL, Laia, 08302 Mataró (ES); FONT BAGÜESTE, Oriol, 08100 Mollet del Vallès (ES); BARNILS RUIZ, Josep, 08186 Lliçà d'Amunt (ES); PASCUAL CUENCA, Enric, 46740 Carcaixent (ES); ARIAS GARCÍA, Francisco Ituriel, 08290 Cerdanyola del Vallès (ES); LÓPEZ PORTA, Aina, 08004 Barcelona (ES)
(74) Representative: Torner, Juncosa I Associats, SL

(57) **Abstract**

Manufacturing method of an electronic device comprising a non-flat laminar item (10) with a non-flat electronic circuit (20) thereon, determining for each surface-mounted component (22) a first breakage threshold above which the adhesion is overcome by loads induced by the local bending and/or stretching of a flat laminar item (10') when forming into the non-flat laminar item (10) through a forming process, and designing a flat electronic circuit (20') to become the non-flat electronic circuit (20) after the forming process, detecting endangered surface-mounted components in danger to be detached and implementing first corrective measures to increment the correspondent first breakage threshold by reducing the surface-mounted component size and/or by modifying the distribution and/or adhesion force of the at least one adhesive, and/or second corrective measures to reduce the local bending and/or stretching by modifying the shape of the non-flat laminar item (10).

## Description

### Technical field

The present invention is directed towards a manufacturing method of an electronic device comprising a non-flat electronic circuit on a non-flat laminar item.

The non-flat electronic circuit includes at least electrically conductive tracks connecting at least one surface-mounted component attached to the non-flat laminar item through at least one adhesive providing a known adhesion force per unit area.

The present invention also covers the electronic device resulting from said method.

### Background of the Invention

The electronic devices, including a non-flat laminar item with a non-flat electronic circuit thereon, obtained through a forming process from a flat laminar item with a flat electronic circuit thereon, are already known. It is also known to over-mold the non-flat laminar item with the non-flat electronic circuit with a structural element through an overmolding process.

During the forming process of the flat laminar item into the non-flat laminar item it suffers local curvatures and stretching, which can produce a separation of one or several of the surface-mounted components from the surface of the non-flat laminar item, or an interruption on some of the electrically conductive tracks, causing a malfunction of the non-flat electronic circuit.

It is also known to over-mold the non-flat laminar item with the non-flat electronic circuit with a structural element through an overmolding process.

During the overmolding process, the molding resin flows before hardening within a mold containing at least a portion of the non-flat electronic circuit, said fluid material flowing around the surface-mounted components pushing said surface-mounted components producing a shear load thereon, which can produce a separation of one or several of the surface-mounted components from the surface of the non-flat laminar item causing a malfunction of the non-flat electronic circuit.

The present invention solves the above and other problems.

### Description of the Invention

According to a first aspect, the present invention concerns a manufacturing method of an electronic device comprising a non-flat laminar item with a non-flat electronic circuit thereon, as defined in claim 1.

The non-flat laminar item is a thin sheet shaped with a three-dimensional geometry including curvatures, for example curvatures in one axis, such as a zero Gaussian curvature, or in two orthogonal axes, such as a positive or negative Gaussian curvature.

Typically, such non-flat item is made of a thermoplastic which becomes deformable when heated, permitting its shaping into the non-flat shape.

The non-flat electronic circuit is supported on the non-flat laminar item, typically being a printed circuit, and includes at least electrically conductive tracks and at least one surface-mounted component.

The surface-mounted components are attached to the non-laminar item and/or to the electrically conductive tracks through at least one adhesive with a known adhesion force per unit area.

Optionally, the dimensions of each surface-mounted component are known, including at least the dimensions of its base surface facing the non-flat laminar item. It is also known the distribution of the above mentioned at least one adhesive on each surface-mounted component to provide attachment thereof.

The adhesive can be located between the surface-mounted component and the non-flat laminar item, between the surface-mounted component and the non-flat electrically conductive tracks, on the perimetral edge of the surface-mounted component, and/or completely covering the surface-mounted component enclosing it in an adhesive shell. Any combination of those adhesive distributions is contemplated, using the same or different types of adhesives with different adhesion force per unit area.

Typically, the adhesive is automatically deposited as drops, the position and spacing between drops being known. Said position and spacing between drops determine the distribution of the at least one adhesive. Also, the viscosity of the adhesive determines the size of each drop, which can be also known as part of the distribution parameter.

Typically, each surface-mounted component has a bottom surface, preferably a flat bottom surface, facing the surface of the non-flat laminar item. A predefined number of drops of adhesive, with a predefined distribution, are placed between the bottom surface and the surface-mounted component and the surface of the non-flat laminar item or the electrically conductive tracks, providing adhesion. Alternatively, the adhesive drops are located in the perimeter of the surface-mounted component and/or completely covering the surface-mounted component enclosing it in an adhesion shell.

An alternative known solution to distribute the adhesive is using a stencil, typically a metal plate, with apertures in those positions where the adhesive shall be applied. The stencil is overlapped to the flat laminar item and the adhesive is distributed over the stencil, reaching the flat laminar item only on predefined position through the apertures, then the stencil is removed and the surface mounted components are placed on the flat laminar item over the adhesive deposited thereon.

The proposed manufacturing method comprises:
defining the shape of a flat laminar item suitable to be deformed into the non-flat laminar item through a forming process producing specific local bending and/or stretching on the flat laminar item during the forming process into the non-flat laminar item;
determining, for each surface-mounted component, or for groups of surface-mounted components, a first breakage threshold above which the adhesion provided by the at least one adhesive is overcome by loads induced by the local bending and/or stretching, leading to a detachment of the surface-mounted component, considering the known adhesion force and distribution of the at least one adhesive and optionally also considering known dimensions of the surface-mounted components; and
designing, on the flat laminar item, a flat electronic circuit to become the non-flat electronic circuit after the forming process.

According to the above, starting from the shape of the non-flat laminar item, which has been previously defined, the shape of a flat laminar item which, through a forming process, can generate the non-flat laminar item is defined, determining which local bending and/or stretching is produced on each region of the flat laminar item during the forming process to become the non-flat laminar item.

The geometry and dimensions of the flat laminar item can be obtained based on the simulation of the forming process. 3D design software and forming simulation software can be used. Such simulation also provides information relative to the local bending and/or stretching suffered by each region of the flat laminar item during its formation into the non-flat laminar item.

Alternatively, the definition of the shape of the flat laminar item can be obtained through an empirical process, using samples, for example samples of flat laminar item with a known pattern drawn thereon which, after the forming process, gets deformed in a measurable manner.

This forming process, also known as thermoforming, involves heating the flat laminar item so that it becomes plastic-deformable and forming the flat laminar item into the non-flat laminar item while it is still hot in the plastic state. The forming can be achieved using a mold. Once the non-flat laminar item is cooled to room temperature it loses its deformable state so that it retains the non-flat shape.

The forming process of a flat laminar item into a non-flat laminar item has known limitations in the maximal stretching and curvature of the flat laminar item. According to that, the non-laminar item will be designed considering said known limitations so that such non-flat laminar item is obtainable through the forming process of a flat laminar item.

The surface-mounted components are attached to the flat laminar item before the forming process by applying the at least one adhesive, and later the flat laminar item is formed into the non-flat laminar item producing local bending and/or stretching of at least some regions thereof.

When the surface-mounted components are on a region of the flat laminar item suffering local bending and/or stretching during the forming process, a detachment thereof can be produced if the local bending and/or stretching overcomes the adhesion provided by the at least one adhesive.

To prevent this detachment, the method comprises determining a first breakage threshold identifying the maximal bending and/or stretching of the laminar item above which such detachment is produced.

To determine the first breakage threshold, the known adhesion force and distribution of the at least one adhesive and the known dimensions of the surface-mounted components are considered.

The first breakage threshold can be determined for each surface-mounted component.

Alternatively, the first breakage threshold can be determined for each group of surface-mounted components, for example, a group of surface-mounted components of equal or similar (within a range) base surface area, width to length ratio, encapsulation and/or adhesion, for example having the same adhesive and the same or similar amount and/or distribution of adhesive.

For example, all the surface-mounted components of the electronic circuit can be grouped on several groups, each group including the surface-mounted components having a similar base surface area and/or similar width to length ratio.

For example, the groups can be defined as groups including surface-mounted components with a base surface area, facing the laminar item, lower than a first value, comprised between the first value and a second value bigger than the first value, or bigger than the second value and/or with a width to length ratio lower than a first value, comprised between the first value and a second value bigger than the first value, or bigger than the second value.

Any number of threshold values can be defined and different criteria for defining the groups can be used.

The groups can be also defined as groups including surface-mounted components adhered with the same adhesive and adhered with the same or similar amount and/or distribution of such adhesive. In this case, the first breakage threshold can be determined for the less favorable surface-mounted component of each group, typically the one with the less favorable amount or distribution of the adhesive. Such first breakage threshold will be used for all the surface-mounted components of the same group.

The distribution of the adhesive is also dependent on the size of the surface-mounted component.

The determination of the first breakage threshold, can be obtained through a simulation of the bending and/or stretching. 3D design software and simulation software can be used.

Alternatively, the definition of the first breakage threshold can be obtained through an empirical process, using samples of the flat laminar item with the surface-mounted components attached thereto.

Preferably, the first breakage threshold is defined as a maximum load, induced by the bending, the stretching and/or a combination of bending and stretching of the flat laminar item during the forming process, supportable for each particular amount and distribution of adhesive, typically for a given component geometry or footprint.

Once the shape of the flat laminar item has been defined, and the first breakage threshold has been determined, the next step is designing on the flat laminar item, a flat electronic circuit to become the non-flat electronic circuit after the forming process, by:
define function determined locations on the non-flat laminar item for some of the surface-mounted components, and identify, on the flat laminar item, precursor locations which, after the forming process, become the function determined locations, positioning said surface-mounted components on the precursor locations;
positioning each of the remaining surface-mounted components in a selected component eligible position of the flat laminar item on which, during the forming process, the local bending and/or stretching is below the first breakage threshold;
verifying if any surface-mounted component is an endangered surface-mounted component placed in one precursor locations with local bending and/or stretching above the first breakage threshold and/or lacks suitable component eligible position.

The function determined locations are positions of the surface-mounted components determined by its function, typically surface-mounted components intended to inform or interact with a user, such a haptic interface, a button, a light emitting element, etc.

Knowing the function determined locations on the non-flat laminar item, the precursor locations on the flat laminar item intended to become the function determined locations after the forming process can be determined, for example through the simulation or the empirical experimentation described above.

The surface-mounted components whose position depends on their function are located in the defined precursor locations.

The local bending and/or stretching on the precursor locations is verified to determine if such bending and/or stretching is above the first breakage threshold or induces loads above the first breakage threshold on the adhesive attachment of the surface-mounted components, corresponding with endangered surface-mounted component in risk to suffer detachment during the forming process.

The remaining surface-mounted components, whose positions do not depend on their function, are distributed on the remaining surface of the flat laminar item.

To distribute those remaining surface-mounted components whose positions do not depend on their function and can therefore be placed in any position on the non-flat laminar item, component eligible positions are identified on the flat laminar item.

The component eligible positions are those positions of the flat laminar item in which the bending/stretching produced during the forming process into the non-flat laminar item generate local bending and/or stretching below the first breakage threshold and are therefore secure locations for placement of the surface-mounted components.

Said component eligible positions will be specific for each first breakage threshold. Therefore, different component eligible positions shall be determined for each surface-mounted component, or for each group of surface-mounted components with the same first breakage threshold.

Once the component eligible positions have been determined, the surface-mounted components are distributed thereon defining, together with the surface-mounted components whose position is determined by its function, the position of all the surface-mounted components of the electronic device.

In some cases, some surface-mounted components lack suitable component eligible positions, or the size of the suitable component eligible positions is insufficient to accommodate all the surface-mounted components required, in which case those become also endangered surface-mounted components, because locating such surface-mounted components in other regions will produce its detachment during the forming process.

When endangered surface-mounted components are detected, the design of the flat electronic circuit shall be modified until no endangered surface-mounted component remains. Such modification may comprise implementing:
first corrective measures to increment the correspondent first breakage threshold by modifying the geometry and/or dimensions of the endangered surface-mounted components to reduce the loads induced by the local bending and/or stretching below them and/or by modifying the adhesion thereof, and/or
second corrective measures to reduce the local bending and/or stretching by modifying the shape of the non-flat laminar item.

The first corrective measures, directed to rise the first breakage threshold at least for the endangered surface-mounted components increasing the areas where they can be placed without suffering detachment, may comprise reducing the size of the surface-mounted components and/or increasing the adhesion force thereof to the support.

This can be achieved, for example, by:
increasing the amount of adhesive attaching the surface-mounted component;
substituting the adhesive attaching the surface-mounted component for an alternative adhesive with a higher known adhesion force per unit area;
adding an alternative adhesive with a different distribution to the adhesive attaching the surface-mounted component;
modifying the distribution of the adhesive to concentrate the adhesive in a central region of the surface-mounted component; or
substituting at least one surface-mounted component for an alternative surface-mounted component with the same functionality but reduced bottom surface facing the non-flat laminar item, reducing the contact surface with the non-flat laminar item.

By modifying the distribution of the at least one adhesive, the adhesion surface thereof may be increased, or only its distribution may be modified, without increasing the surface area, for example to make the adhesive drops closer to each other reducing the lever and the relative displacement between said drops. The distribution of the adhesive may be also modified, for example, by moving the adhesive from below the surface-mounted component to its perimeter or vice-versa.

By reducing the size of the surface-mounted component the surface suffering local bending and/or stretching of the laminar item is also reduced, thus reducing the lever and the relative displacement between opposed ends of the surface-mounted component, permitting to withstand higher bending and/or stretching and therefore rising the first breakage threshold.

Another additional first corrective measure may comprise substitute the adhesive for another adhesive with a higher adhesion force per unit area or combining two different types of adhesives with different distributions, for example one adhesive below the surface-mounted component and another different adhesive around it.

Any of the above first corrective measures, or a combination thereof, will result in a rise in the first breakage threshold, increasing the areas of the flat laminar item where said surface-mounted component can be placed without becoming an endangered surface-mounted component.

If the first corrective measures listed above are not sufficient to solve all the endangered surface-mounted components, the second corrective measures can be implemented. Said second corrective measures comprises modifying the shape of the non-flat laminar item to reduce the local bending and/or stretching at least where one endangered surface-mounted component is intended to be placed, or where minor shape modifications are required to allow the safe location of the endangered surface-mounted components.

Also, a combination of first and second corrective measures are possible.

Once all the endangered surface-mounted components have been solved by the first or first and second corrective measures, the location of all the surface-mounted components has been finally determined, then the electrically conductive paths can be also distributed on the flat laminar item to connect the surface-mounted components defining the flat electronic circuit, which will become the non-flat electronic circuit after the forming process.

Then, the flat laminar item with the flat electronic circuit thereon shall be produced according to the design obtained from the preceding steps of the method, and later formed into the non-flat laminar item with the non-flat electronic circuit thereon through the forming process.

The non-flat laminar item will be designed by defining the exact volumetric shape thereof. Typically, such shape is defined to be complementary with a support on which such electronic device has to be attached, for example an interior surface of a vehicle.

According to one embodiment of the present invention, the method further comprises determining, for each electrically conductive track, or for groups of electrically conductive tracks, such similarly wide electrically conductive tracks, a second breakage threshold above which the local bending and/or stretching induces loads overcoming the mechanical properties of the electrically conductive track leading to an interruption of its electrical conductivity, and wherein the designing of the flat electronic circuit further includes positioning the electrically conductive tracks entirely in track eligible positions on which, during the forming process, the local bending and/or stretching is below the second breakage threshold.

The second breakage threshold can be defined by calculation, using simulations, or through empirical experimentation, considering a tolerable curvature and/or stretching of the electrically conductive tracks determined considering at least fabrication material and thickness of the electrically conductive tracks, which determines the maximal curvature and/or stretching supportable by said electrically conductive tracks without affecting the required conduction of electricity through it, i.e. maintaining the conductivity of the electrically conductive paths above a threshold necessary to maintain a normal operation of the electronic circuit.

Typically, the second breakage threshold allows for bigger bending and/or stretching than the first breakage threshold.

The method may also comprise detecting, as part of the track eligible positions, track eligible paths along which the curvature and/or stretching during the forming process is below the second breakage threshold, the track eligible paths being oblique to a local maximal curvature and/or stretching direction on which the local curvature and/or stretching produced during the forming process is above the second breakage threshold.

According to that, the method can further comprise identifying track eligible paths which can be, for example, oblique, zigzagging or orthogonal to the local direction with maximal local bending and/or with maximal local stretching. The apparent bending and/or stretching, in the direction of such track eligible path, is lower than the local bending and/or stretching in the direction with maximal local bending and/or with maximal local stretching.

Therefore, the bending and/or stretching along the track eligible paths can be below the second breakage threshold despite being in a region which maximal local bending and/or maximal local stretching is above the second breakage threshold.

If any electrically conductive track lacks a suitable track eligible position with local bending and/or stretching producing induced loads below the correspondent second breaking threshold, the design of the non-flat electronic circuit may be modified to increase the second breakage threshold of at least those electrically conductive tracks lacking suitable track eligible positions by modifying the width and/or thickness of the electrically conductive track or parts thereof; or by modifying the constitutive material of the electrically conductive tracks.

The curvature and the stretching of the non-flat laminar area are directional, therefore those curvature and stretching on each point are maximum in one direction and minimal in another direction, said two directions being typically orthogonal to each other.

According to that, an area could be outside the track eligible area because its maximum curvature and/or its maximum stretching is too high, therefore ineligible for the tracks according embodiment exposed above, but in some cases on those ineligible areas a track eligible path can be determined in a direction different to the maximum curvature or maximum stretching direction, where the apparent curvature and the apparent stretching in the direction of the track eligible path are lower than the maximum curvature and the maximum stretching and below the curvature and the stretching supportable by the electrically conductive tracks considering the track breaking limit, i.e. that an electrically conductive track can be implemented outside the track eligible area if it follows one of such track eligible paths.

It will be understood that a zigzagging track eligible path is a path constituted of multiple successive segments, each segment being oblique or transverse to the maximal curvature and/or to the maximal stretching of the non-laminar item.

According to an additional embodiment, the method can further comprise defining, as part of the designing of the flat electronic circuit, additional function determined locations on the non-flat laminar item for printed sensors or printed actuators, such capacitive sensors, and identifying, on the flat laminar item, additional precursor locations which, after the forming process, become the additional function determined locations. Then, the method comprises printing printed sensors or printed actuators on the additional precursor locations as part of the flat electronic circuit.

The printed sensors or printed actuators may be located in a position defined by its functionality. Those positions are the additional function determined locations.

Optionally, the method further comprises determining, for each printed sensor or printed actuator, a third breakage threshold above which the local bending and/or stretching induces loads on the printed sensors or printed actuators which overcomes the mechanical properties of the printed sensor or printed actuator leading to an interruption on its functionality.

If any printed sensor or printed actuator is placed in one additional precursor locations suffering bending and/or stretching inducing loads above the third breakage threshold, then the design of the non-flat electronic circuit can be modified to implement third corrective measures to increment the correspondent third breakage threshold of the printed sensor or printed actuator or implementing the second corrective measures described above, consistent in modifying the shape of the non-flat laminar item.

Typically, the third breakage threshold allows for bigger bending and/or stretching than the first breakage threshold, but less than the second breakage threshold.

The third corrective measures may include modifying the width and/or thickness of the printed sensor or printed actuator or parts thereof, modifying the constitutive material of the printed sensor or printed actuator; or increasing the size of the printed sensor or printed actuator.

Modifying the shape or size of the printed sensor or printed actuator or modifying the thickness or width of the constitutive elements thereof, may produce an increase in the third breakage threshold.

According to an embodiment, the method further comprises designing a structural element to be overmolded on, or around, the non-flat laminar item and designing an overmolding process to produce the structural element and determining local flow parameters of the molding resin over the non-flat laminar item during the overmolding process.

Such local flow parameters may include for example parameters such as the fluid molding resin flow speed, direction, viscosity, temperature, or others before hardening, on each region of the non-flat laminar item during the overmolding process.

For each surface-mounted component, or for each group of surface-mounted components, for example, a group of surface-mounted components of equal or similar (within a range) base surface area, width to length ratio, encapsulation and/or adhesion, a fourth breakage threshold is determined. The fourth breakage threshold is a threshold above which the adhesion provided by the at least one adhesive is overcome by loads induced by the molding resin injected according to the local flow parameters during the overmolding process, leading to a detachment of the surface-mounted component, considering the known adhesion force and distribution of the at least one adhesive and the known dimensions of the surface-mounted components.

Each surface-mounted component protrudes from the non-flat laminar item and therefore presents an obstacle against the flowing of the molding resin during the overmolding process. The flow of molding resin surrounding the surface-mounted components generates forces on such surface-mounted components, which can be sufficient to overcome the adhesion leading to a detachment thereof.

Most of the detaching will be generated by a shear load produced on the adhesive due to a lateral pushing force produced by the flow of the molding resin injected during the overmolding process on one lateral side of the surface-mounted component. The larger the exposed side surface of the surface-mounted component, and the faster and denser the flow of injected molding resin, the worse.

The surface-mounted components of the electronic circuit can be divided in several groups, grouping those surface-mounted components having the same or similar size and having the same type of adhesive, including the same or similar amount of adhesive and/or with the adhesive having the same of similar distribution. For example, all the surface-mounted components of the electronic circuit can be grouped on several groups, each group including the surface-mounted components adhered with the same adhesive and adhered with the same or similar amount and/or distribution of such adhesive.

In this case, the fourth breakage threshold can be determined for the less favorable surface-mounted component of each group, typically the one with the less favorable amount or distribution of the adhesive. Such fourth breakage threshold will be used for all the surface-mounted components of the same group.

Then, the proposed method may comprise verifying if any surface-mounted component is an endangered surface-mounted component suffering loads above the fourth breakage threshold induced by local flow parameters. When endangered surface-mounted components are detected, modifying the design of the flat electronic circuit until no endangered surface mounted component remains by implementing:
Fourth corrective measures consisting of modifying the position of each endangered surface-mounted component to a position with local flow parameters inducing loads below the fourth breakage threshold to prevent the detachment produced during the overmolding process and with bending and/or stretching inducing loads below the first breakage threshold to prevent the detaching during the forming process.
Fifth corrective measures to increase the correspondent fourth breakage threshold above the loads induced by the local flow parameters by modifying the geometry and/or dimensions of the endangered surface-mounted components to reduce the loads induced by the local bending and/or stretching below them and/or by modifying the adhesion thereof.

The modification of the geometry and/or dimensions of the endangered surface mounted components can be obtained, for example, by substituting the surface-mounted component for an alternative surface mounted component with the same functionality but reduced cross-section surface perpendicular to the flat laminar item, which reduces the drag force against the flow of molding resin and/or with a bigger bottom surface facing the flat laminar item when more adhesive can be applied..

By modifying the geometry and/or dimensions of the endangered surface mounted components, the surface suffering local bending and/or stretching of the laminar item is also reduced, thus reducing the lever and the relative displacement between opposed ends of the surface-mounted component, permitting to withstand higher bending and/or stretching and therefore rising the first breakage threshold.

The fifth corrective measures may also comprise modifying the distribution of the at least one adhesive, to increase the adhesion surface thereof, to make the adhesive drops closer to each other reducing the lever and the relative displacement between said drops or to modify to position of the adhesive, for example moving the adhesive from below the surface-mounted component to its perimeter or vice-versa.

Sixth corrective measures to optimize the local flow parameters at least on regions coincident with the endangered surface-mounted components to reduce the shear and/or temperature therein by modifying the overmolding process.

The sixth corrective measures may include reducing the molding resin viscosity and/or speed and/or temperature during the overmolding process to reduce the local flow parameters, and/or modify the position and/or number of injection gates of the mold through which the molten plastic is introduced in the mold during the overmolding process.

The local flow parameters depend on the definition of the overmolding process. Such overmolding process can be modified to modify the local flow parameters at least in some locations, for example by modifying the position and/or number of the injection gates in the mold to modify the flow direction at least on some areas, by modifying the injection speed, by modifying the plastic viscosity or by using a different plastic composition.

Optionally, at least one surface-mounted component may have an anisotropic cross-section surface. In this case, the fourth breakage threshold thereof may be an anisotropic fourth directional breakage threshold variable depending on directional orientation of the force applied on the surface-mounted component. For example, the lateral exposed surface area of the surface-mounted component can be variable depending on the orientation thereof, and the attachment provided by the adhesive may be also dependent on the direction, for example if the adhesive is distributed in a non-radially symmetric manner or following an elongated pattern.

At least some of the local flow parameters can also be anisotropic directional local flow parameters variable depending on directional orientation. For example, the local direction or local speed of the molding resin are directional parameters.

The method may comprise verifying if any surface-mounted component is an endangered surface-mounted component suffering, in at least one direction, loads induced by the directional local flow parameters in said direction above the fourth directional breakage threshold supportable in the same direction.

When endangered surface-mounted components are detected, modifying the design of the flat electronic circuit until no endangered surface mounted component remains by implementing the fourth corrective measures, the fifth corrective measures, the sixth corrective measures and/or seventh corrective measures including the modification of the orientation of the surface-mounted component.

If the orientation of the surface-mounted component is modified, the same surface-mounted component with the same adhesion may withstand the same loads produced thereof without requiring any additional modification, simply by orienting the surface-mounted component in a better orientation optimized to increase its load resistance or to reduce the induced loads generated thereon.

The method steps related to the detachment produced due to the flow of molding resin can be implemented independently to other features described in the present invention, and therefore can be protected in a divisional application without such features.

Preferably, the first breakage threshold and/or the fourth breakage threshold and/or the fourth directional breakage threshold is/are defined individually for each surface-mounted component.

It is also proposed that, for at least one surface-mounted component, the adhesive attaching said surface-mounted component is an electrically conductive adhesive interposed between electrically connections of the surface-mounted component and the electrically conductive tracks, providing simultaneously adhesion and electrical connection. This electrically conductive adhesive can be combined with non-electrically conductive adhesive/s in the same surface-mounted component to increase the adhesion.

### Brief description of the Figures

The foregoing and other advantages and features will be more fully understood from the following detailed description of an embodiment with reference to the accompanying drawings, to be taken in an illustrative and non-limitative manner, in which:
Fig. 1 shows a perspective view of the non-flat laminar item, in which the three-dimensional relief has been indicated by topography lines and in which two function determined locations for two surface-mounted components and one additional function determined location for one printed sensor or printed actuator have been indicated with a dashed line rectangle;

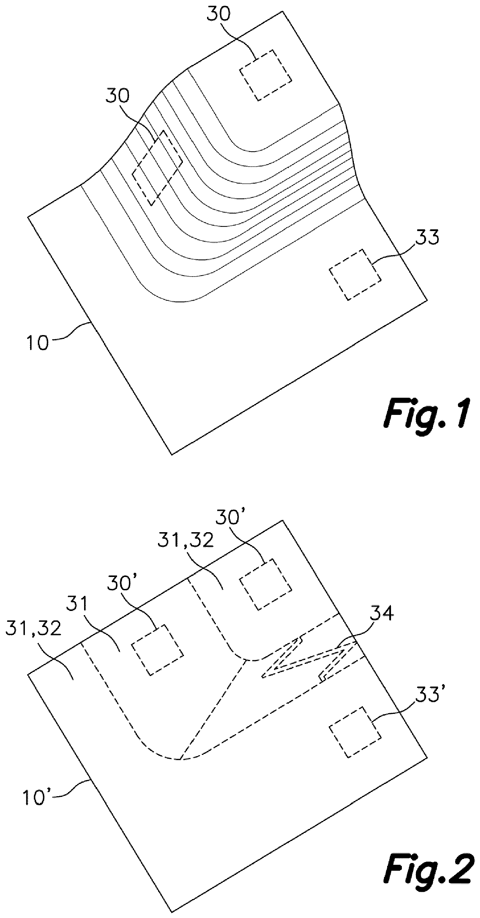

Fig. 2 shows a perspective view of the flat laminar item from which the non-flat laminar item shown in Fig. 1 can be obtained through a forming process, in which two precursor locations for two surface-mounted components and one additional precursor location for one printed sensor or printed actuator have been indicated with a dashed line rectangle, which will become the two function determined locations and the one additional function determined location indicated in Fig. 1, and wherein the different regions of the flat laminar item, suffering different bending and/or stretching during the forming process, have been indicated with dashed lines;

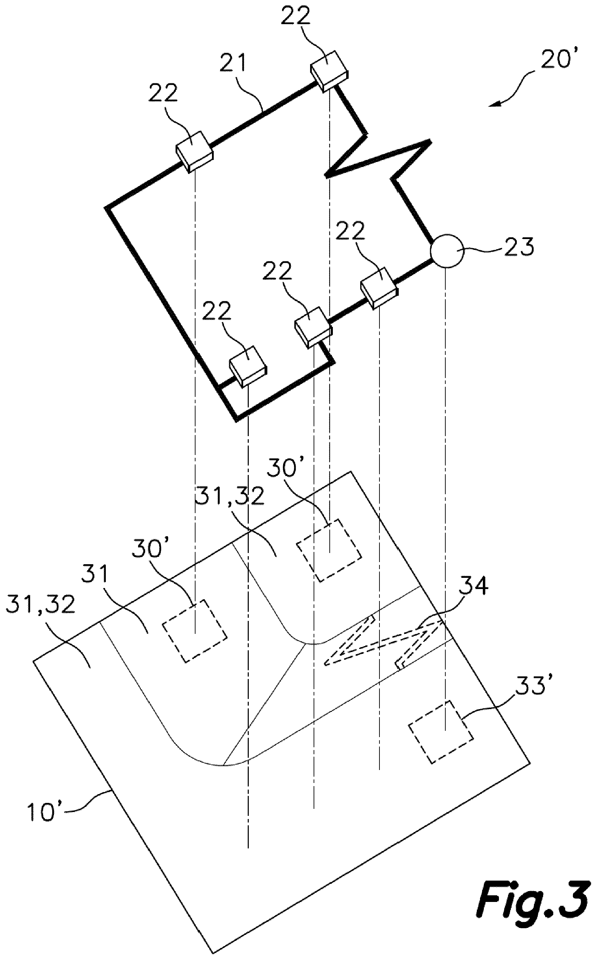

Fig. 3 shows an exploded perspective view of the flat laminar item shown in Fig. 2, with a flat electronic circuit thereon;
Fig. 4 shows a perspective ensembled view of the flat laminar item with a flat electronic circuit shown in Fig. 3;
Fig. 5 shows a perspective view of the electronic device including a non-flat laminar item with the non-flat electronic circuit obtained through a forming process from the flat laminar item with the flat electronic circuit shown in Fig. 4;

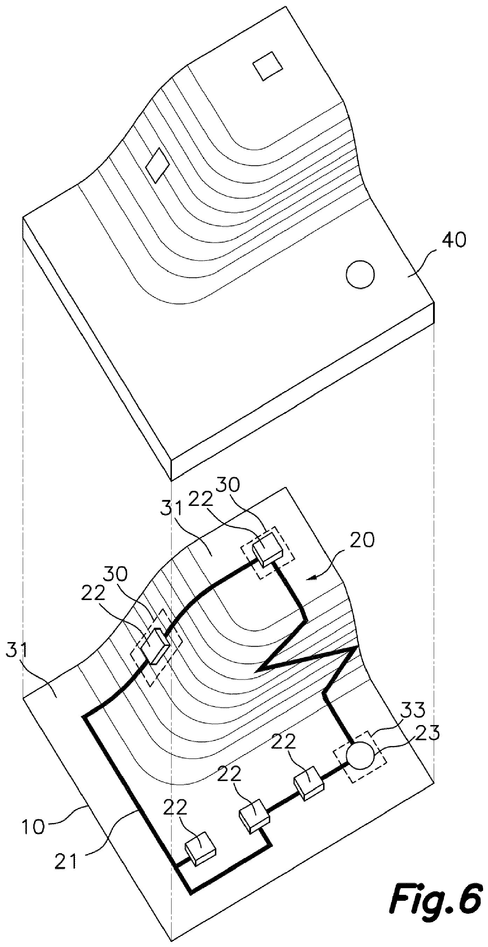

Fig. 6 shows an exploded perspective view of the electronic device shown in Fig. 5 with an structural element overmolded thereon;

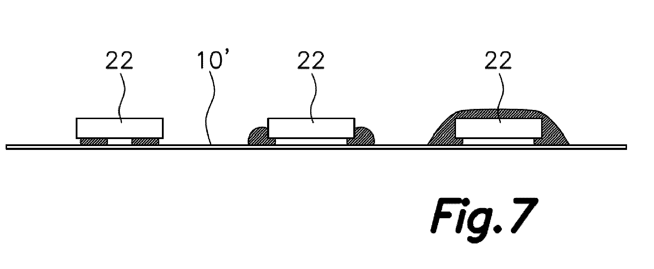

Fig. 7 shows a transversal cross-section of a flat laminar item with three surface-mounted components attached with adhesive, showing three different possible adhesive distributions.

### Detailed Description of the Invention and of particular embodiments

The proposed electronic device is shown in the Figures according to a preferred embodiment, only as a non-limitative example.

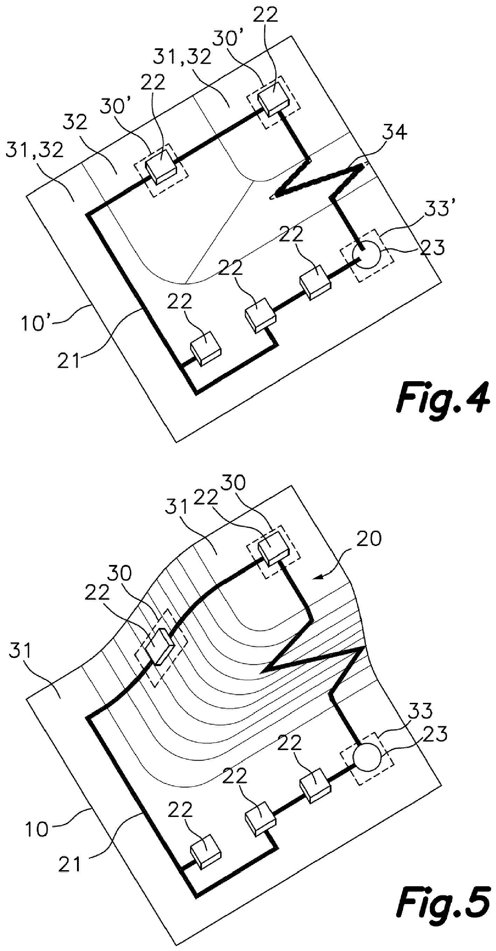

The electronic device shown in Fig. 5 comprises a non-flat laminar item 10, with a predefined three dimensional shape, with a non-flat electronic circuit 20 applied thereon, the non-flat electronic circuit comprising surface-mounted components 22, electrically conductive tracks 21 and optionally printed sensors or printed actuators 23.

Some of those surface-mounted components have to be in a specific predefined function defined position 30 on the non-flat laminar item 10. Optionally, some of the printed sensors or printed actuators 23 shall be also located in a specific predefined additional function defined position 33 on the non-flat laminar item 10.

The three-dimensional shape of the non-flat laminar item 10 and the location of the function defined position 30, and of the additional function defined position 33 within said three-dimensional non-flat laminar item 10 are designed, for example, considering the function of the electronic device, the placement thereof and/or considering aesthetic criteria.

According to the above, the proposed method comprises first determining the shape of the non-flat laminar item 10 and the location of the function determined locations 30 and optionally of the additional function determined locations 33 thereon, as shown in Fig. 1.

Later, the shape of a flat laminar item 10' from which the non-flat laminar item 10 can be obtained through a forming process is determined, for example through a simulation of the forming process, identifying the local bending and/or stretching suffered of each region of the flat laminar item 10' during the formation of the non-flat laminar item 10, and also identifying on the flat laminar item 10' the position of precursor locations 30', which will become the function determined locations 30 after the forming process, and the position of additional precursor locations 33', which will become the additional function determined locations 33 after the forming process.

The method also comprises defining the scheme of the flat electronic circuit 20' required to produce the electronic functionality of the electronic device, identifying each surface-mounted component 22, with known dimensions, and the electrically conductive tracks 21 required to obtain such electronic functionality, and optionally also printed sensors or printed actuators 23 of this flat electronic circuit 20'.

The surface-mounted components 22 are classified in two groups, one group containing the surface-mounted components 22 which position on the non-flat laminar item 10 is determined by its function, for example those surface-mounted components intended to interact with a user, such buttons and lights, and another group containing the rest of the surface-mounted components 22 which position can be freely modified.

Similarly, the printed sensors or printed actuators are also classified in those which position is determined by its function and the rest, but in this case most or all of them will be in the first group.

Also, initial adhesive parameters are determined for each surface-mounted component 22, including the adhesive type, with a known adhesion force per unit area, and the distribution thereof on each surface-mounted component 22 to provide attachment thereof on the flat laminar item 10' and/or on the electrically conductive tracks 21.

Then, for each surface-mounted component 22, a first breakage threshold is determined, for example through empirical experimentation or through simulation. The first breakage threshold is the limit above which the adhesion provided by the adhesive is overcome by the loads induced by the local bending and/or stretching of the flat laminar item 10' during the formation of the non-flat laminar item, such the traction loads produced on the adhesive by the bending of the substrate and/or the shear loads produced on the adhesive by the stretching of the substrate.

Such limit can be expressed, for example, as a maximal local bending, a maximal local stretching and/or a maximal combination of local bending and local stretching, suffered for the flat laminar item 10' during the forming process on the local region on which the surface-mounted component 22 is adhered, supportable for the adhesive without producing a detachment thereof.

Alternatively, the surface-mounted components 22 are classified in several groups, each group including those surface-mounted components 22 with the same adhesive and with similar amount and distribution thereof. Then, the first breakage threshold is determined for the surface-mounted component with the weakest adhesion of each group and considered as the first breakage threshold for all the surface-mounted components 22 of the group.

Similarly, a third breakage threshold can be determined for each printed sensor or printed actuator, or group of printed sensors or printed actuators, said third breakage threshold being also the maximal bending and/or stretching supportable by the printed sensor or printed actuator 23 without losing functionality.

Then, the geometry of the flat electronic circuit 20' is determined, locating each surface-mounted component 22 which position depends on its function on the correspondent precursor location 30' of the flat laminar item 10', and also locating each printed sensor or printed actuator 23 which position depends on its function on the correspondent additional precursor location 33' of the flat laminar item 10' when exist.

Also, component eligible regions are determined on the surface of the flat laminar item 10' for each surface-mounted component 22 or for each group of surface-mounted components with the same first breakage threshold. The component eligible regions are those regions of the flat laminar item 10' having local bending and/or stretching below said first breakage threshold and can be easily determined considering the known local bending and/or stretching of the flat laminar item 10' during the forming process and the first breakage threshold. Then, those surface-mounted components 22 which position does not depend on its function, are distributed within the component eligible regions.

Similarly, sensor eligible regions are determined on the surface of the flat laminar item 10' for each printed sensor or printed actuator 23 or group of printed sensors or printed actuators with the same third breakage threshold which position does not depend on its functionality. The sensor eligible regions are those regions of the flat laminar item 10' having local bending and/or stretching below said third breakage threshold and can be easily determined considering the known local bending and/or stretching of the flat laminar item 10' during the forming process and the third breakage threshold. Then, those printed sensors or printed actuators 23 which position does not depend on its function, are located in any position within the sensor eligible regions.

If some of the precursor locations 30' suffer a bending and/or stretching above the first breakage threshold of the correspondent surface-mounted component 22 located therein is considered an endangered surface-mounted component and corrective measures, selected between first and second corrective measures, have to be implemented for those endangered surface-mounted component.

Also, if no component eligible regions, or not big enough component eligible regions exist to accommodate some surface-mounted component 22 or group of surface-mounted components 22 which position is not dependent on its function, then those surface-mounted components are also considered endangered surface-mounted components for which corrective measures selected between the first and second corrective measures have to be implemented.

A first corrective measure may comprise:
increasing the amount of adhesive attaching the surface-mounted component;
substituting the adhesive attaching the surface-mounted component for an alternative adhesive with a higher known adhesion force per unit area;
adding an alternative adhesive with a different distribution to the adhesive attaching the surface-mounted component;
modifying the distribution of the adhesive to concentrate the adhesive in a central region of the surface-mounted component; or
substituting at least one surface-mounted component for an alternative surface-mounted component with the same functionality but reduced bottom surface facing the non-flat laminar item, reducing the contact surface with the non-flat laminar item.

Any of those first corrective measures, or combination thereof, may increase the first breakage threshold for the correspondent surface-mounted component 22 above the local bending and/or stretching on the correspondent precursor location 30' during the forming process or may expand the correspondent component eligible regions.

If those first corrective measures are not sufficient, then second corrective measures shall be implemented, consisting in the modification of the three-dimensional shape of the non-flat laminar item 10, at least in the function determined location 30 or in the regions of the flat laminar item 10' suffering less bending and/or stretching during the forming process, to reduce the local bending and/or stretching therein during the forming process below the first breakage threshold.

Also, for each electrically conductive track 21 or for each group of electrically conductive tracks, a second breakage threshold is determined, for example through empirical experimentation or through simulation. The second breakage threshold is the limit above which the electrically conductive tracks suffer a deformation by the local bending and/or stretching of the flat laminar item 10' during the formation of the non-flat laminar item which affects its electrical conductivity. Such limit can be expressed, for example, as a maximal local bending, a maximal local stretching and/or a maximal combination of local bending and local stretching, suffered for the flat laminar item 10' during the forming process on the local region on which the electrically conductive track 21 is applied without affecting its electrical conductivity.

Electrically conductive tracks 21 can be classified in several groups, each group including those electrically conductive tracks 21 with similar wide. Then, the second breakage threshold is determined for the less wide electrically conductive track 21 of each group and considered as the second breakage threshold for all the electrically conductive tracks 21 of the group.

Tracks eligible regions are determined on the surface of the flat laminar item 10' for each electrically conductive track or for each group of electrically conductive tracks with the same second breakage threshold. The tracks eligible regions are those regions of the flat laminar item 10' having local bending and/or stretching below said second breakage threshold and can be easily determined considering the known local bending and/or stretching of the flat laminar item 10' during the forming process and the second breakage threshold. Then, the electrically conductive tracks 21 are distributed within the track eligible regions, according the electric scheme to obtain the intended electronic functionality.

In some cases, the connection between surface-mounted components 22 require the electrically conductive tracks 21 to be defined across a region not initially defined as a track eligible region. In those cases, track eligible paths 34 can be determined across those regions not initially defined as a track eligible region as part of the track eligible regions.

The track eligible paths can be for example, oblique, zigzagging or orthogonal to the local direction with maximal local bending and/or with maximal local stretching. The apparent bending and/or stretching, in the direction of such track eligible path, is lower than the local bending and/or stretching in the direction with maximal local bending and/or with maximal local stretching.

Therefore, the bending and/or stretching along the track eligible paths 34 can below the second breakage threshold despite being in a region which maximal local bending and/or maximal local stretching is above the second breakage threshold.

Then, some electrically conductive tracks 21 can be implemented in the track eligible paths 34.

The electronic device may include a structural element 40 overmolded above or around the non-flat laminar item 10 with the non-flat electronic circuit 20 thereon.

In this case, the method may include designing the structural element 40 to be overmolded and also designing an overmolding process to produce the structural element 40, defining the molding resin to be overmolded, and the molding parameters thereof, for example the fluid molding resin viscosity, temperature, injection velocity before hardening and/or the location of the injection gates through which the fluid molding resin is introduced in the mold.

The material to be overmolded can be, for example, thermoplastic, silicon rubber, thermoset resins.

Then, the local flow parameters of the molding resin over the non-flat laminar item 10 during the overmolding process are determined. Such local flow parameters may include, for example, parameters of the molding resin on each region of the non-flat laminar item during the overmolding process, for example, the molding resin flow speed, direction, viscosity, temperature, or others before hardening.

For each surface-mounted component 22, or for groups of surface-mounted components 22, a fourth breakage threshold can be determined through empirical experimentation or computer simulation. Above the fourth breakage threshold the adhesion provided by the at least one adhesive is overcome by the loads induced by the local flow of fluid molding resin according to the local flow parameters during the overmolding process before hardening, leading to a detachment of the surface-mounted component 22. The determination of the fourth breakage threshold is obtained considering the known adhesion force and distribution of the at least one adhesive and the known dimensions of the surface-mounted components.

If any surface-mounted component 22 is an endangered surface-mounted component suffering induced loads above the fourth breakage threshold, then the design of the flat electronic circuit 20' shall be modified until no endangered surface-mounted component remains, by implementing fourth, fifth or sixth corrective measures.

The fourth corrective measures consisting of modifying the position of each endangered surface-mounted component to a position with local flow parameters inducing loads below the fourth breakage threshold to prevent the detachment produced during the overmolding process and with bending and/or stretching inducing loads below the first breakage threshold to prevent the detaching during the forming process.

The fifth corrective measures consist of reducing the surface-mounted component size and/or modifying the distribution and/or adhesion force of the at least one adhesive to increment the correspondent fourth breakage threshold above the loads induced by the local flow parameters.

The fifth corrective measures may also comprise modifying the distribution of the at least one adhesive, to increase the adhesion surface thereof, to make the adhesive drops closer to each other reducing the lever and the relative displacement between said drops or to modify to position of the adhesive, for example moving the adhesive from below the surface-mounted component to its perimeter or vice-versa.

## Claims

1. Manufacturing method of an electronic device comprising a non-flat laminar item (10) with a non-flat electronic circuit (20) thereon, the non-flat electronic circuit (20) including at least electrically conductive tracks (21) and at least one surface-mounted component (22) attached through at least one adhesive, the method comprising:
defining the geometry and dimensions of a flat laminar item (10') suitable to be deformed into the non-flat laminar item (10) through a forming process producing specific local bending and/or stretching on the flat laminar item (10') during the forming process into the non-flat laminar item (10);
determining, for each surface-mounted component (22), or for groups of surface-mounted components (22), a first breakage threshold above which the adhesion thereof is overcome by loads induced by the local bending and/or stretching, leading to a detachment of the surface-mounted component (22), considering a known distribution and adhesion force per unit area of the at least one adhesive on each surface-mounted component (22); and
designing, on the flat laminar item (10'), a flat electronic circuit (20') to become the non-flat electronic circuit (20) after the forming process, by:
defining function determined locations (30) on the non-flat laminar item (10) for some of the surface-mounted components (22), and identify, on the flat laminar item (10'), precursor locations (30') which, after the forming process, become the function determined locations (30), positioning said surface-mounted components (22) on the precursor locations (30');
positioning each of the remaining surface-mounted components (22) in a selected component eligible position (31) of the flat laminar item (10') on which, during the forming process, the local bending and/or stretching induces loads below the first breakage threshold;
verifying if any surface-mounted component (22) is an endangered surface-mounted component placed in one precursor location (30') with local bending and/or stretching inducing loads above the first breakage threshold and/or lacking suitable component eligible position (31);
when endangered surface-mounted components are detected, modifying the design of the flat electronic circuit (20') until no endangered surface mounted component remains by implementing:
first corrective measures to increment the correspondent first breakage threshold by modifying the geometry and/or dimensions of the endangered surface-mounted components to reduce the loads induced by the local bending and/or stretching below them and/or by modifying the adhesion thereof, and/or
second corrective measures to reduce the local bending and/or stretching by modifying the shape of the non-flat laminar item (10);
producing the flat laminar item (10') with the flat electronic circuit (20') thereon according to the design obtained from the preceding steps of the method and form the non-flat laminar item (10) with the non-flat electronic circuit (20) thereon through the forming process.

2. The manufacturing method according to claim 1 wherein the method further comprises determining, for each electrically conductive track (21), or for groups of electrically conductive tracks (21), a second breakage threshold above which the local bending and/or stretching induces loads overcoming the mechanical properties of the electrically conductive track (21) leading to an affectation on its electrical conductivity sufficient to jeopardize the normal operation of the electronic circuit, and wherein the designing of the flat electronic circuit (20') further includes positioning the electrically conductive tracks (21) entirely in track eligible positions (32) on which, during the forming process, the local bending and/or stretching is below the second breakage threshold.

3. The manufacturing method according to claim 2 wherein the method comprises detecting, as part of the track eligible positions (32), track eligible paths (34) along which the curvature and/or stretching during the forming process is below the second breakage threshold, the track eligible paths (34) being oblique to a local maximal curvature and/or stretching direction on which the local curvature and/or stretching produced during the forming process is above the second breakage threshold.

4. The manufacturing method according to claim 1, 2 or 3 wherein the method further comprises:
defining, as part of the designing of the flat electronic circuit (20'), additional function determined locations (33) on the non-flat laminar item for printed sensors or printed actuators (23), and identifying, on the flat laminar item (10'), additional precursor locations (33') which, after the forming process, become the additional function determined locations (33);
printing the printed sensors or printed actuators (23) on the additional precursor locations (33') as part of the flat electronic circuit (20').

5. The manufacturing method according to claim 4 wherein the method further comprises:
determining, for each printed sensor or printed actuator (23), a third breakage threshold above which the local bending and/or stretching induces loads on the printed sensor or printed actuator which overcomes the mechanical properties thereof leading to an interruption on its functionality; and
if any printed sensor or printed actuator (23) is placed in one additional precursor locations (33') suffering bending and/or stretching inducing loads above the third breakage threshold, modifying the design of the non-flat electronic circuit (20) implementing third corrective measures to increment the correspondent third breakage threshold of the printed sensor or printed actuator (23) by modifying the shape or size of the printed sensor or printed actuator (23) and/or by modifying the thickness or width of at least parts of the printed sensor or printed actuator (23), or implementing the second corrective measures.

6. The manufacturing method according to any preceding claim wherein the method further comprises
designing a structural element (40) to be overmolded on, or around, the non-flat laminar item (10) and designing an overmolding process to produce the structural element (40);
determining local flow parameters of the moulding resin injected over the non-flat laminar item (10) during the overmolding process;
determining, for each surface-mounted component (22), or for groups of surface-mounted components (22), a fourth breakage threshold above which the adhesion provided by the at least one adhesive is overcome by loads induced by the local flow of fluid molding resin before hardening according to the local flow parameters during the overmolding process, leading to a detachment of the surface-mounted component (22), considering the known adhesion force and distribution of the at least one adhesive and the known dimensions of the surface-mounted components;
verifying if any surface-mounted component (22) is an endangered surface-mounted component suffering loads above the fourth breakage threshold induced by local flow parameters,
when endangered surface-mounted components are detected, modifying the design of the flat electronic circuit (20') util no endangered surface mounted component remains by implementing:
fourth corrective measures consisting of modifying the position of each endangered surface-mounted component to a position with local flow parameters inducing loads below the fourth breakage threshold and with bending and/or stretching inducing loads below the first breakage threshold; and/or
fifth corrective measures to increment the correspondent fourth breakage threshold above the loads induced by the local flow parameters by modifying the geometry and/or dimensions of the endangered surface-mounted components to reduce the loads induced by the local bending and/or stretching below them and/or by modifying the adhesion thereof; and/or
sixth corrective measures to optimize the local flow parameters at least on regions coincident with the endangered surface-mounted components to reduce the shear and/or temperature therein by modifying the overmolding process.

7. The manufacturing method according to claim 6 wherein
at least one surface-mounted component (22) has an anisotropic cross-section surface, and the fourth breakage threshold thereof is an anisotropic fourth directional breakage threshold variable depending on directional orientation,
at least some of the local flow parameters are anisotropic directional local flow parameters variable depending on directional orientation;
verifying if any surface-mounted component is an endangered surface-mounted component suffering, in at least one direction, loads induced by the directional local flow parameters in said direction above the fourth directional breakage threshold supportable in the same direction; and
when endangered surface-mounted components are detected, modifying the design of the flat electronic circuit util no endangered surface mounted component remains by implementing the fourth corrective measures, the fifth corrective measures, the sixth corrective measures and/or seventh corrective measures consisting in the modification of the orientation of the surface-mounted component.

8. The manufacturing method according to any preceding claim wherein the first breakage threshold and/or the fourth breakage threshold and/or the fourth directional breakage threshold is/are defined individually for each surface-mounted component.

9. The electronic device according to any preceding claim wherein the at least one adhesive attaching at least one surface-mounted component is an electrically conductive adhesive interposed between electrically connections of the surface-mounted component and electrically conductive tracks.

10. The electronic device according to any preceding claim wherein the first corrective measures to increase the first breakage threshold include, for at least one surface-mounted component suffering induced loads above the first breakage threshold:
increasing the amount of adhesive attaching the surface-mounted component;
substituting the adhesive attaching the surface-mounted component for an alternative adhesive with a higher known adhesion force per unit area;
adding an alternative adhesive with a different distribution to the adhesive attaching the surface-mounted component;
modifying the distribution of the adhesive to concentrate the adhesive in a central region of the surface-mounted component; or
substituting at least one surface-mounted component for an alternative surface-mounted component with the same functionality but reduced bottom surface facing the non-flat laminar item, reducing the contact surface with the non-flat laminar item.

11. The electronic device according to claim 2 or 3 wherein if any electrically conductive track lacks a suitable track eligible position with local bending and/or stretching producing induced loads below the correspondent second breaking threshold, modifying the design of the non-flat electronic circuit to increase the second breakage threshold of at least those electrically conductive tracks lacking suitable track eligible positions by:
modify the wide and/or thickness of the electrically conductive track or parts thereof; or
modify the material constitutive of the electrically conductive tracks.

12. The electronic device according to claim 5 wherein the third corrective measures to increase the third breakage threshold include, for at least one printed sensor or printed actuator suffering induced loads above the third breakage threshold:
modify the wide and/or thickness of the printed sensor or printed actuator or parts thereof;
modify the material constitutive of the printed sensor or printed actuator; or
increase the size of the printed sensor or printed actuator.

13. The electronic device according to claim 6, 7 or 8 wherein the fifth corrective measures to increase the fourth breakage threshold include, for at least one surface-mounted component suffering induced loads above the fourth breakage threshold:
substituting the surface-mounted component for an alternative surface mounted component with the same functionality but reduced cross-section surface perpendicular to the flat laminar item to reduce drag and/or with a bigger bottom surface facing the flat laminar item to increase adhesion; or
increasing the adhesion force by replacing the at least one adhesive by an adhesive with stronger adhesion force per unit area, by modifying the distribution of the at least one adhesive, by increasing the quantity of the at least one adhesive, and/or by adding a quantity of a different additional adhesive; and/or
wherein the sixth corrective measures to optimize the local flow parameters at least on the regions where induce loads on surface-mounted components above the fourth breakage threshold include:
reduce the molding resin viscosity and/or speed and/or temperature during the overmolding process to reduce the local flow parameters;
modify the position and/or number of injection gates of the mold through which the molten molding resin is introduced in the mold during the overmolding process.
